# EUROPEAN PATENT SPECIFICATION

(11) **EP 3 476 910 B1**
(45) Date of publication and mention of the grant of the patent: **15.12.2021**
(21) Application number: 18202949.6
(22) Date of filing: 26.10.2018
(51) Int. Cl.: C09G 1/02

(54) **COMPOSITE PARTICLES, METHOD OF REFINING AND USE THEREOF**
KOMPOSITPARTIKEL, VERFAHREN ZUR VERFEINERUNG UND VERWENDUNG DAVON
PARTICULES COMPOSITES, PROCÉDÉ DE RAFFINAGE ET UTILISATION ASSOCIÉE

(30) Priority: 27.10.2017 US 201762577978 P; 12.10.2018 US 201816159572
(43) Date of publication of application: 01.05.2019
(60) Divisional application: 21154152.9
(73) Proprietor: Versum Materials US, LLC, Tempe, AZ 85284 (US)
(72) Inventor: ROSE, Joseph D, Tempe, Arizona 85284 (US); MURELLA, Krishna P., Tempe, Arizona 85284 (US); ZHOU, Hongjun, Tempe, Arizona 85284 (US)
(74) Representative: Beck Greener LLP

(56) References cited:
- EP-A1- 3 231 848
- ZHANG Z ET AL: "Synthesis, characterization of ceria-coated silica particles and their chemical mechanical polishing performance on glass substrate", APPLIED SURFACE SCIENCE, ELSEVIER, AMSTERDAM, NL, vol. 257, no. 5, 15 December 2010 (2010-12-15), pages 1750-1755, XP027431586, ISSN: 0169-4332, DOI: 10.1016/J.APSUSC.2010.09.009 [retrieved on 2010-10-21]

## Description

### BACKGROUND OF THE INVENTION

Chemical mechanical planarization ("CMP") polishing compositions (CMP slurries, CMP composition or CMP formulations are used interchangeably) are used in the production of a semiconductor device. The present invention relates to polishing compositions comprising refined composite particles (used as abrasive particles) that are especially suitable for polishing patterned semiconductor wafers that comprise silicon oxide materials.

Silicon oxide is widely used as dielectric material in semiconductor industry. There are several CMP steps in integrated circuit (IC) manufacturing process, such as shallow trench isolation (STI), inter-layer dielectric (ILD) CMP and gate poly CMP etc. Typical oxide CMP slurry involves: abrasive, with or without other chemicals. Other chemicals could be dispersants to improve slurry stability, boosters to increase removal rate, or inhibitors to decrease removal rate and to stop on the other film, for example, SiN for STI application.

Desirable characteristics for a CMP slurry at advanced semiconductor technology nodes are reduced defects, high removal rates, very low within wafer non-uniformity (WWNU) for removal rates and low topography. Having a very low WWNU for removal rates is particularly important. A higher non-uniformity would lead to over-polish in the regions on the wafers where removal rates and under-polish where least material is removed. This would create uneven topography on the wafer surface which is undesirable in semiconductor manufacturing. Therefore, considerable CMP process development is required in terms of pads, conditioning, polishing zone pressure adjustments to yield desired uniform removal rate profile.

Among common abrasives used in CMP slurries, such as silica, alumina, zirconia, titania and so on, ceria is well-known for its high reactivity toward silica oxide and is widely used in STI CMP slurry for the highest oxide removal rate (RR) due to the high reactivity of ceria to silica.

Cook et al. (Lee M. Cook, Journal of Non-Crystalline Solids 120 (1990) 152-171) proposed a 'chemical tooth' mechanism to explain this extraordinary property of ceria. According to this mechanism, when ceria particles are pressed onto silicon oxide film, ceria breaks down silica bonds, forms a Ce-O-Si structure and thus cleavage silica from the surface.

Most of the ceria used in CMP industry are manufactured from calcinations-wet milling process. The resulted ceria has sharp edges and very wide size distribution. It also has very large "large particle count" (LPC). All of these are believed to be responsible for defects and low yields, especially scratch after the wafer is polished. Different forms of ceria containing particles such as colloidal ceria or ceria coated silica particles are also being considered to resolve these challenging issues.

Ceria coated silica particles have been found especially useful for achieving high removal rates of silicon oxide films with lower defectivity (PCT/US16/12993, US2016358790, US2017133236, US201783673). Yet the need exists still to further improve the removal rates, control the removal rate within-wafer-non-uniformity(WWNU) and reduce polishing defects.

EP 3 231 848 A1 discloses an aqueous CMP composition for the selective removal of TEOS silica over SiN on semiconductor substrates, having a pH of 3,5-10 and comprising: 0,01-20 wt % composite particles such as ceria-coated silica particles having D50/(D99-D50) of e.g. 1,7 (sample RE2003); ammonium polyacrylate having a molecular weight of 15000-18000.

The present invention relates to ceria coated composite particles in polishing applications that can achieve the performance requirements.

Therefore, there are significant needs for CMP compositions, methods, and systems that can offer excellent within wafer non-uniformity for removal rates and higher removal rates and low defects.

### BRIEF SUMMARY OF THE INVENTION

Described herein are composite particles with certain particle size distributions useful for making CMP polishing compositions, slurry, or formulations for polishing semiconductor wafers that provide improved planarity.

The invention is a polishing method for chemical mechanical planarization (CMP) of a semiconductor substrate comprising at least one surface having at least one oxide layer, wherein the oxide layer includes TEOS and high density plasma (HDP) silicon dioxide, comprising the steps of: a) contacting the at least one oxide layer with a polishing pad; b) delivering a CMP polishing composition comprising; (1) 0.01 wt.% to 20 wt.% of composite particles comprising core particles selected from the group consisting of silica, alumina, titania, zirconia, polymer particles, and combinations thereof; and nanoparticles selected from the group consisting of oxides of zirconium, titanium, iron, manganese, zinc, cerium, yttrium, calcium, magnesium, fluorine, lanthanum, and strontium, and combinations thereof; wherein the composite particles have a particle size distribution of D50/(D99-D50) ≤ 1.85; D99 is a particle size that 99 wt.% of the composite particles fall on and under, and D50 is a particle size that 50 wt.% of the composite particles fall on and under; (2) water soluble solvent selected from the group consisting of water, a polar solvent and a mixture of water and polar solvent; wherein the polar solvent is selected from the group consisting of alcohol, ether, ketone, or other polar reagent; (3) wherein the pH of the CMP composition is in the range of 2 to 12; and wherein the composition optionally further comprises one or more of (4) 0.0001 wt.% to 5 wt.% of a pH adjusting agent selected from the group consisting of sodium hydroxide, cesium hydroxide, potassium hydroxide, cesium hydroxide, ammonium hydroxide, quaternary organic ammonium hydroxide, and combinations thereof; (5) 0.000001 wt.% to 5 wt.% of a chemical additive selected from the group consisting of a compound selected from the group consisting of organic carboxylic acids, amino acids, amide carboxylic acids, N-acylamino acids, and salts thereof; organic sulfonic acids and salts thereof; organic phosphonic acids and salts thereof; polymeric carboxylic acids and salts thereof; polymeric sulfonic acids and salts thereof; polymeric phosphonic acids and salts thereof; arylamines, amino alcohols, aliphatic amines, heterocyclic amines, hydroxamic acids, substituted phenols, sulfonamides, thiols, polyols having hydroxyl groups, and combinations thereof; (6) 0.0001 wt.% to 10 wt.% of a surfactant selected from the group consisting of a). Non-ionic surface wetting agents; b). Anionic surface wetting agents; c). Cationic surface wetting agents; d). ampholytic surface wetting agents; and mixtures thereof; (7) 0.01 wt.% to 3.0 wt.% of chelators; (8) corrosion inhibitor; (9) oxidizer; and (10) biological growth inhibitor; and c) polishing the at least one oxide layer with the CMP polishing composition, wherein the ratio of removal rate of TEOS to removal rate of HDP silicon dioxide film is < 1.

The mean particle size (MPS) of the core particles may range from 10 nm to 500 nm, preferably between 20 nm to 200nm, more preferably between 50 nm and 150 nm. The core particles are larger than the nanoparticles. MPS of the core particle size in a composite particle may be measured by a suitable imaging technique such as transmission electron microscopy imaging.

Particle size distribution can be measured by any suitable techniques such as imaging, dynamic light scattering, hydrodynamic fluid fractionation, disc centrifuge etc. Particle size analysis by disc centrifuge method is a preferred analysis. Disc centrifuge creates a gradient of particles based on size using centrifugal sedimentation as the larger particles get centrifuged faster compared to smaller particles. Light intensity at the edge of centrifuge disc as a function of centrifugation time and converts the intensity signal into particle size distribution.

Particle size distribution may be quantified as a weight percentage of particles that has a size lower than a specified size. For example, parameter D99 represents a particle diameter where 99 wt.% of all the slurry particles would have particle diameter equal to or smaller than the D99. D50 would represent a particle diameter where 50 wt.% of all the slurry particles would have particle diameter equal to or smaller than the D50. Similarly, parameters such as D5, D10, D75, D90, D95 can also

be defined. D50 of ceria coated silica particles may range from 10 nm to 500nm, preferably between 15 nm to 250nm, more preferably between 20 nm and 200 nm.

In some preferred embodiments, it is desirable to have a wide particle size distribution. The particle size distribution width can be characterized by for example by calculating the difference between a suitable high end of particle size and the middle of the particle size distribution, e.g. D99-D50. The values can also be used to normalize the size of the particle, e.g. D50/(D99-D50). Or alternatively more complex calculations may be performed to determine polydispersity of the slurry.

In some preferred embodiments, the particle size distribution width characterized by D50/(D99-D50) is ≤ 1.85, preferably ≤ 1.50, and more preferably ≤ 1.30, and most preferably less than 1.25.

In certain embodiments, ceria coated silica particles with different core particle sizes may be mixed to create a wider particle size distribution.

CMP formulations may also additionally comprise additives for changing film removal rate selectivity between different films, surfactants, dispersing agents, pH adjusting agents and biological growth inhibitors.

The pH adjusting agent includes but is not limited to sodium hydroxide, cesium hydroxide, potassium hydroxide, cesium hydroxide, ammonium hydroxide, quaternary organic ammonium hydroxide, and combinations thereof.

The chemical additive includes but is not limited to a compound having a functional group selected from the group consisting of organic carboxylic acids, amino acids, amino carboxylic acids, N-acylamino acids, and their salts thereof; organic sulfonic acids and salts thereof; organic phosphonic acids and salts thereof; polymeric carboxylic acids and salts thereof; polymeric sulfonic acids and salts thereof; polymeric phosphonic acids and salts thereof; arylamines, aminoalcohols, aliphatic amines, heterocyclic amines, hydroxamic acids, substituted phenols, sulfonamides, thiols, polyols having hydroxyl groups, and combinations thereof.

The composite particles can comprise single ceria coated silica particles and aggregated ceria coated silica particles; wherein 99 wt.% of the composite particles have mean particle size less than 250 nm, preferably less than 200 nm, and more preferably less than 190 nm.

The ceria coated silica particles can further have mean particle size less than 150 nm, preferably less than 125 nm, or more preferably less than 110 nm; wherein the mean particle size is the weighted average of particle diameters.

The ceria coated silica particles are amorphous silica ceria particles having surfaces covered by singly crystalline ceria nanoparticles.

The change of size distribution of composite particles under a disintegrative force is less than 10%, preferably less than 5%, or more preferably less than 2%.

When the semiconductor substrate further comprising a nitride layer, the CMP polishing provides a removal selectivity of the at least one oxide layer over the nitride layer is more than 10. The removal selectivity of TEOS over silicon nitride layer is more than 20.

### BRIEF DESCRIPTION OF SEVERAL VIEWS OF THE DRAWINGS

Figure 1 shows the particle size distributions of various ceria coated silica particles by Disc Centrifuge Particle Size Analyzer.
Figure 2 shows the schematic of pattern wafer structure and the measurement scheme used
Figure 3 plots the ratio of the trench oxide loss rate to blanket oxide removal rate as the function of D50/(D90-D50) for the CMP slurries with different particles.

### DETAILED DESCRIPTION OF THE INVENTION

### Composition Particles

Composite particles contain primary (or single) particles and aggregated primary (or single) particles. A primary particle has a core particle and many nanoparticles covering the surface of the core particle.

The core particle is selected from the group consisting of silica, alumina, titania, zirconia, and polymer particles. The nanoparticles are selected from the group consisting of oxides of zirconium, titanium, iron, manganese, zinc, cerium, yttrium, calcium, magnesium, fluorine, lanthanum and strontium nanoparticles.

One of the examples of the composite particles is to have silica as the core particles and ceria as the nanoparticles; and each silica core particle has ceria nanoparticles covering its shell. The surface of each silica particle is covered by ceria nanoparticles. The nanoparticles covering the silica core particles may also have a thin layer of silicon containing films covering the surface either partially or fully.

A preferred abrasive particle for CMP applications is ceria coated silica particles.

Ceria coated silica particles can be made using any suitable methods. For example, methods to make such particles are described in PCT/JP2016/060535, JP6358899, JP2017043531, JP2017193692, JP2017206410, JP2017206411, WO18088088, WO18131508, JP2016127139, US6645265, US9447306, JP5979340, WO2005/035688 and US2012/077419.

Typically, the method of forming composite particles, such as, ceria coated silica particles involves deposition of cerium compounds on silica core particles, followed by a calcination step and a milling step. However, the calcination step results in agglomeration of particles. Some examples of the ways to reduce the number of aggregated particles would be to use lower calcination conditions such as lower temperature or calcination time, more aggressive milling conditions, use of dispersants during milling, use of post-milling processing such as centrifugation or filtering or any other technique that reduces the number of aggregated particles.

In some preferred embodiments, it is desirable to have a wide particle size distribution. The particle size distribution width can be characterized by for example by calculating the difference between a suitable high end of particle size and the middle of the particle size distribution, e.g. D99-D50. The values can also be normalized with respect to size of the particle, e.g. D50/(D99-D50). Or alternatively more complex calculations may be performed to determine polydispersity of the slurry.

In some preferred embodiment, the D50 may range from 10 nm to 500nm, preferably between 15 nm to 250nm, more preferably between 20 nm and 200 nm.

In some preferred embodiments, the particle size distribution width characterized by D50/(D99-D50) is ≤ 1.85, preferably ≤ 1.50, and more preferably ≤ 1.30, and most preferably less than 1.25.

In certain embodiments, ceria coated silica particles with different mean particle sizes may be mixed together to create wider particle size distributions.

### Chemical mechanical planarization (CMP)

The refined aggregated particles can be used as abrasive particles in CMP compositions (or CMP slurries, or CMP formulations).

An example is STI (Shallow Trench Isolation) CMP formulations, to polish oxide films, such as various metal oxide films; and various nitride films. In STI formulations, the formulations comprising silica coated ceria composite particles can provide very high removal rates of silicon oxide films and very low removal rates of silicon nitride polish stop films. These slurry formulations can be used to polish a variety of films and materials including but not limited to thermal oxide, Tetra Ethyl Ortho Silicate (TEOS), High Density Plasma (HDP) oxide, High Aspect Ratio Process (HARP) films, fluorinated oxide films, doped oxide films, organosilicate glass (OSG) low-K dielectric films, Spin-On Glass (SOG), polymer films, flowable Chemical Vapor Deposited (CVD) films, optical glass, display glass.

The formulations can also be used in stop-in-film applications, where the polishing is stopped once the topography is removed and a flat surface is achieved. Alternatively, these formulations can be used in applications that involve polishing the bulk film and stopping at a stopper layer. These formulations can be used in a variety of applications including but not limited to Shallow Trench Isolation (STI), Inter Layer Dielectric (ILD) polish, Inter Metal Dielectric (IMD) polish, through silicon via (TSV) polish, poly-Si or amorphous-Si film polishing, SiGe films, Ge films and III-V semiconductor films.

The formulations may also be used in any other applications such as glass polishing or solar wafer processing or wafer grinding where high removal rates are desired.

In certain embodiments, polishing formulations can be used to polish silicon oxide films at polish rates greater than 2000 Angstroms/min.

In some other embodiments, the ratio of TEOS removal rate to High Density Plasma silicon oxide films is ≤1 or more preferably less than 0.9 or most preferably less than 0.8.

Another aspect of use of ceria coated silica particles that do not disintegrate under polishing forces. It is hypothesized that if the particles do not breakdown under the action of polishing forces (i.e. disintegrative forces) and keep the characteristic of original particle size, then the removal rate would remain high. If the particles on the other hand disintegrate under polishing forces, the removal rate would decrease as the ceria nanoparticles on the surface responsible for high removal rates may come loose. Breaking of the particles may also yield irregular shaped particles which may have undesirable effect on scratching defects.

Using such stable particles in CMP slurry formulations would allow more effective utilization of polishing forces for film material removal and would also prevent generation of any irregular shapes that would contribute to scratching defects.

Since advanced CMP applications require extremely low levels of metals such as sodium on the dielectric surface after polishing, it is desired to have very low trace metals, especially sodium in the slurry formulations. In certain preferred embodiments the formulations comprise ceria coated silica particles that have less than 5 ppm, more preferably less than 1 ppm most preferably less than 0.5 ppm of sodium impurity levels for each percent of particles in the formulations by weight.

The CMP composition comprises refined composite particles as abrasive particles, the remaining is a water soluble solvent selected from the group consisting of water, a polar solvent and a mixture of water and polar solvent; wherein the polar solvent is selected from the group consisting of alcohol, ether, ketone, or other polar reagent; and pH of the CMP composition ranges from about 2 to about 12;

The abrasive is present in an amount from 0.01 wt % to 20 wt%, preferably, from 0.05 wt % to 5 wt%, more preferably, from about 0.1wt % to about 1 wt %.

Chemical additive includes, but is not limited, to a compound having a functional group selected from the group consisting of organic carboxylic acids, amino acids, amino carboxylic acids, N-acylamino acids, and their salts thereof; organic sulfonic acids and salts thereof; organic phosphonic acids and salts thereof; polymeric carboxylic acids and salts thereof; polymeric sulfonic acids and salts thereof; polymeric phosphonic acids and salts thereof; arylamines, aminoalcohols, aliphatic amines, heterocyclic amines, hydroxamic acids, substituted phenols, sulfonamides, thiols, polyols having hydroxyl groups, and combinations thereof.

The amount of chemical additive ranges from about 0.1 ppm (or 0.000001 wt. %) to 5 wt. % relative to the total weight of the barrier CMP composition. The preferred range is from about 200 ppm (or 0.02 wt.%) to 1.0 wt.% and more preferred range is from about 500 ppm (or 0.05 wt.%) to 0.5 wt. %.

The pH-adjusting agent includes, but is not limited to, sodium hydroxide, cesium hydroxide, potassium hydroxide, cesium hydroxide, ammonium hydroxide, quaternary organic ammonium hydroxide (e.g. tetramethylammonium hydroxide) and mixtures thereof.

The amount of pH-adjusting agent ranges from about 0.0001 wt % to about 5 wt % relative to the total weight of the CMP composition. The preferred range is from about 0.0005 % to about 1 wt %, and more preferred range is from about 0.0005wt % to about 0.5 wt %.

The pH of the CMP composition ranges from 2 to about 12; preferably about 3.5 to about 10; more preferably from about 4 to about 7.

For certain CMP applications such as Shallow Trench Isolation (STI) or oxide polish for 3D-NAND devices, it may be desirable to polish using CMP formulations preferably in the range of 3 to 8 or most preferably between 4 to 7 in order to reduce dishing in the oxide line features as well as to reduce loss of silicon nitride stopping layers. For certain applications such as barrier metal polishing, the desirable pH range may be 5 to 12, or more preferably between 8 to 11.

The CMP composition may comprise a surfactant or mixture of surfactants. Surfactant may be selected from groups comprising a). Non-ionic surfactants; b). Anionic surfactants; c). Cationic surfactants; d). ampholytic surfactants; and mixtures thereof.

Non-ionic surfactants may be chosen from a range of chemical types including but not limited to long chain alcohols, ethoxylated alcohols, ethoxylated acetylenic diol surfactants, polyethylene glycol alkyl ethers, propylene glycol alkyl ethers, glucoside alkyl ethers, polyethylene glycol octyl phenyl ethers, polyethylene glycol alkyl phenyl ethers, glycerol alkyl esters, polyoxyethylene glycol sorbiton alkyl esters, sorbiton alkyl esters, cocamide monoethanol amine, cocamide diethanol amine dodecyl dimethylamine oxide, block copolymers of polyethylene glycol and polypropylene glycol, polyethoxylated tallow amines, fluorosurfactants. The molecular weight of surfactants may range from several hundreds to over 1 million. The viscosities of these materials also possess a very broad distribution.

Anionic surfactants include, but are not limited to salts with suitable hydrophobic tails, such as alkyl carboxylate, alkyl polyacrylic salt, alkyl sulfate, alkyl phosphate, alkyl bicarboxylate, alkyl bisulfate, alkyl biphosphate, such as alkoxy carboxylate, alkoxy sulfate, alkoxy phosphate, alkoxy bicarboxylate, alkoxy bisulfate, alkoxy biphosphate, such as substituted aryl carboxylate, substituted aryl sulfate, substituted aryl phosphate, substituted aryl bicarboxylate, substituted aryl bisulfate, substituted aryl biphosphate etc. The counter ions for this type of surface wetting agents include, but are not limited to potassium, ammonium and other positive ions. The molecular weights of these anionic surface wetting agents range from several hundred to several hundred-thousands.

Cationic surface wetting agents possess the positive net charge on major part of molecular frame. Cationic surfactants are typically halides of molecules comprising hydrophobic chain and cationic charge centers such as amines, quaternary ammonium, benzyalkonium and alkylpyridinium ions.

Yet, in another aspect, the surfactant can be an ampholytic surface wetting agents possess both positive (cationic) and negative (anionic) charges on the main molecular chains and with their relative counter ions. The cationic part is based on primary, secondary, or tertiary amines or quaternary ammonium cations. The anionic part can be more variable and include sulfonates, as in the sultaines CHAPS (3-[(3-Cholamidopropyl)dimethylammonio]-1-propanesulfonate) and cocamidopropyl hydroxysultaine. Betaines such as cocamidopropyl betaine have a carboxylate with the ammonium. Some of the ampholytic surfactants may have a phosphate anion with an amine or ammonium, such as the phospholipids phosphatidylserine, phosphatidylethanolamine, phosphatidylcholine, and sphingomyelins.

Examples of surfactants also include, but are not limited to, dodecyl sulfate sodium salt, sodium lauryl sulfate, dodecyl sulfate ammonium salt, secondary alkane sulfonates, alcohol ethoxylate, acetylenic surfactant, and any combination thereof. Examples of suitable commercially available surfactants include TRITON ^{™}, Tergitol^{™}, DOWFAX^{™} family of surfactants manufactured by Dow Chemicals and various surfactants in SUIRFYNOL^{™}, DYNOL^{™}, Zetasperse^{™}, Nonidet^{™}, and Tomadol^{™} surfactant families, manufactured by Air Products and Chemicals. Suitable surfactants of surfactants may also include polymers comprising ethylene oxide (EO) and propylene oxide (PO) groups. An example of EO-PO polymer is Tetronic^{™} 90R4 from BASF Chemicals.

Other surfactants that have functions of dispersing agents and/or wetting agents include, but are not limited to, polymeric compounds which may have anionic or cationic or nonionic or zwitterionic characteristics. Examples are polymers/copolymers containing functional groups such as acrylic acid, maleic acid, sulfonic acid, vinyl acid, ethylene oxide, etc.

The amount of surfactant ranges from about 0.0001 wt% to about 10 wt % relative to the total weight of the CMP composition. The preferred range is from about 0.001 wt% to about 1 wt %, and more preferred range is from about 0.005 wt % to about 0.1 wt %.

Formulations may also comprise water soluble polymers which may comprise anionic or cationic or non-ionic or combinations of groups. The polymer/copolymer has molecular weights greater than 1,000, ranging preferably from 10,000 to 4,000,000; and more preferably from 50,000 to 2,000,000. Polymers can be selected from a group of polymers including, but not limited to poly(acrylic acid), poly(meth-acrylic acid), poly(2-acrylamido-2-methyl-1-propanesulfonic acid, carboxymethyl cellulose, methyl cellulose, hydroxypropyl methyl cellulose, poly-(1-vinylpyrroliddone-co-2-dimethylaminoethyl methacrylate). Polymer concentration in the CMP formulation may be in the range of 0.001 wt% to 5 wt% or more preferably between 0.005 wt% to 2 wt% or most preferably between 0.01 wt% and 1 wt%.

Chelators, or chelating ligands may also be used to enhance affinity of chelating ligands for metal cations especially in the applications involving polishing of metallic films. Chelating agents may also be used to prevent build-up of metal ions on pads which causes pad staining and instability in removal rates. Suitable chelators, or chelating ligands include, but are not limited to, for example, benzenesulfonic acid, 4-tolyl sulfonic acid, 2,4-diamino-benzosulfonic acid, and etc., and also non-aromatic organic acids, such as itaconic acid, malic acid, malonic acid, tartaric acid, citric acid, oxalic acid, gluconic acid, lactic acid, mandelic acid, or salts thereof The amount of chelators, or chelating ligands ranges from about 0.01 wt% to about 3.0 wt% relative to the total weight of the CMP composition; preferably from about 0.4 wt% to about 1.5wt%.

The polishing composition may further comprise a corrosion inhibitor for metal polishing applications. Suitable corrosion inhibitors include, but are not limited to: benzotriazole (BTA) or BTA derivatives, 3-amino-1, 2, 4-triazole, 3, 5-diamine-1, 2, 4-triazole, other triazole derivatives, and combinations thereof.

The polishing composition includes an oxidizing agent, or oxidizer. The oxidizing agent can be any suitable oxidizing agent. Suitable oxidizing agents include, but are not limited to, one or more peroxy-compounds, which comprise at least one peroxy group ( O ). Suitable peroxy-compounds include, for example, peroxides, persulfates (e.g., monopersulfates and dipersulfates), percarbonates, and acids thereof, and salts thereof, and mixtures thereof. Other suitable oxidizing agents include, for example, oxidized halides (e.g., iodates, periodates, and acids thereof, and mixtures thereof, and the like), perboric acid, perborates, percarbonates, peroxyacids (e.g., peracetic acid, perbenzoic acid, salts thereof, mixtures thereof, and the like), permanganates, cerium compounds, ferricyanides (e.g., potassium ferricyanide), mixtures thereof, and the like.

The CMP composition may comprise biological growth inhibitors or preservatives to prevent bacterial and fungal growth during storage.

The biological growth inhibitors include, but are not limited to, tetramethylammonium chloride, tetraethylammonium chloride, tetrapropylammonium chloride, alkylbenzyldimethylammonium chloride, and alkylbenzyldimethylammonium hydroxide, wherein the alkyl chain ranges from 1 to about 20 carbon atoms, sodium chlorite, and sodium hypochlorite.

Some of the commercially available preservatives include KATHON^{™} and NEOLENE^{™} product families from Dow Chemicals, and Preventol^{™} family from Lanxess. More are disclosed in U.S. Pat. No. 5,230,833 (Romberger et al.) and US Patent Application No. US 20020025762.

Formulations may be made into concentrate and be diluted at the point of use. Alternatively, the formulations can be made into 2 or more multiple components and mixed at the point of use.

### PARAMETERS:

Å: angstrom(s) ― a unit of length
BP: back pressure, in psi units
CMP: chemical mechanical planarization = chemical mechanical polishing
CS: carrier speed
DF: Down force: pressure applied during CMP, units psi
min: minute(s)
ml: milliliter(s)
mV: millivolt(s)
psi: pounds per square inch
PS: platen rotational speed of polishing tool, in rpm (revolution(s) per minute)
SF: polishing composition flow, ml/min
TEOS - oxide films by Chemical Vapor Deposition (CVD) using tetraethylorthosilicate as the precursor
HDP- oxide films made by high density plasma (HDP) technique
SiN films- Silicon nitride films
Removal Rates and Selectivity
Removal Rate (RR) = (film thickness before polishing - film thickness after polishing)/polish time.

Slurry formulations in subsequent examples use water as the remainder of the slurry formulation. All percentages are weight percentages unless otherwise indicated.

### Working Examples

CMP Polisher: 200 mm wafer polisher Mirra, manufactured by Applied Materials, and Polishing Pad IC1010 pad, supplied by Dow Corporation were used for CMP process.

Ammonium polyacrylate (molecular weight 15000-18000), purchased from Kao chemicals, sold under trade name EK-1, as polymeric carboxylic acid salt chemical additive.

pH of CMP formulations was adjusted to 5 using ammonium hydroxide.

Particle size distribution measurements were performed using the Disc Centrifuge Particle Size Analyzer (DC24000 UHR from CPS Instruments). Particle size distribution curves were generated based on assumption that particle size density of the composite particles is 3.64 gm/cm³ calculated based on the composition of the particle.

### Example 1

Four different kinds of ceria coated silica abrasive particles were obtained from JGC&C Corporation, Japan. Particle size distribution of these four particles were summarized in table I.

**Table 1: Particle size distribution summary**

| **Particle** | **D99 (nm)** | **D50 (nm)** | **D99-D50 (nm)** | **D50/(D99-D50)** | **Number of Peaks** |
|---|---|---|---|---|---|
| A | 302.6 | 156.1 | 146.5 | 1.07 | 4 |
| B | 182.7 | 117.2 | 65.5 | 1.79 | 2 |
| C | 316.7 | 210.7 | 106 | 1.99 | 2 |
| D | 158.5 | 88.7 | 69.8 | 1.27 | 2 |

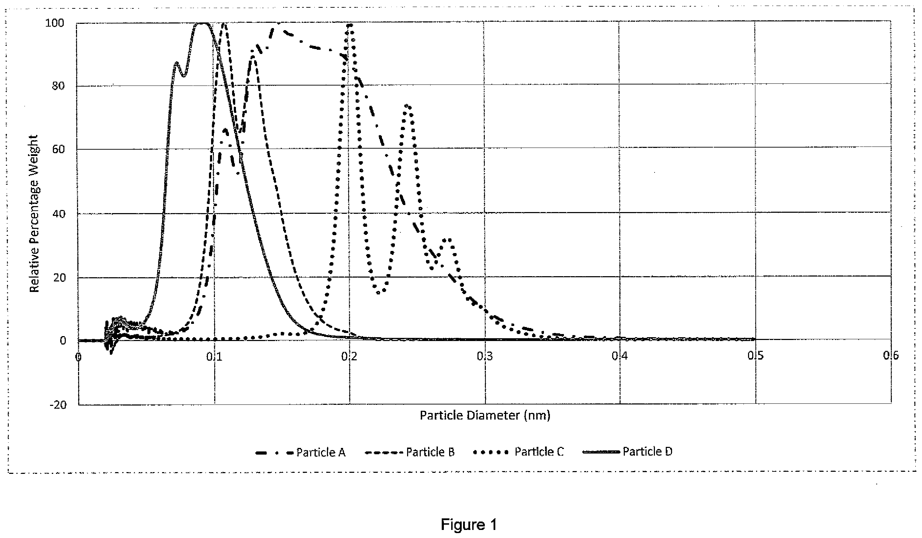

Figures 1 depicted the particle size distributions of these particles.

There were multiple peaks in particle size distribution plots as shown in Fig. 1. Each peak corresponds to a cluster that is formed by aggregate of two or more single primary particles. Particles B, C and D were manufactured using a process to tightly control the particle size distribution to two particle size peaks indicating most of the clusters have 2 or less primary particles. Particle A manufactured using a different process on the other hand had a very broad size distribution with 4 peaks indicating presence of particle size clusters comprising two or more primary particles.

### Example 2

Polishing was performed on Mirra polisher manufactured by Applied Materials. Polishing was performed at 3.7 psi (27 kPa) with 87 RPM table speed 93 RPM head speed, 200 ml/min slurry flow rate with in-situ pad conditioning at 6 lb (27 N) downforce.

These particles as described in Example 1 were individually formulated as abrasives into CMP polishing slurries comprising 0.185 wt.% abrasive particles, 0.14 wt.% ammonium polyacrylate (MW -16000-18000), pH adjusted to 5.45 using ammonium hydroxide.

Table 2 summarized the removal rates for different films obtained by polishing with the CMP polishing slurries.

**Table 2**

| | TEOS films (Angstroms/min) | High Density Plasma (HDP) oxide films (Angstroms/min) | TEOS/HDP removal rate ratio |
|---|---|---|---|
| A | 1311 | 2041 | 0.64 |
| B | 1828 | 1807 | 1.01 |
| C | 2223 | 2299 | 0.97 |
| D | 875 | 1158 | 0.76 |

It is evident that the particle size and particle size distribution affected HDP silicon dioxide films and TEOS films differently even though both films essentially comprise silicon oxide films.

Particle A with larger particle size distribution appeared to provide much higher removal rates for HDP silicon dioxide films compared to a similar sized particle with narrower particle size distribution.

Particle D with smaller particle size similarly appeared to provide higher removal rates for HDP silicon dioxide films compared to TEOS films.

Particles B and C were relatively insensitive for the polishing of HDP silicon dioxide films or TEOS films.

A combination of smaller particle size and wide size distribution therefore may be helpful in polishing HDP silicon dioxide films preferentially.

### Example 3

In this example, the effect of abrasive particles on sensitivity of line dishing or over-polish was determined.

Patterned wafers with MIT864 pattern were used for polishing. Wafer was first polished with a calcined ceria slurry (STI2100 from Versum Materials) to fully clear HDP oxide from the field regions. The wafer was then polished for two times with 60 second polish time. After each polish-step, remaining SiN thickness in the filed region and the HDP oxide thickness in the trench regions were measured using ellipsometric techniques. Based on this data, over polish sensitivity was calculated by dividing trench oxide loss rate (pattern removal rate) by the HDP oxide blanket oxide removal rate. Higher trench loss relative to blanket oxide rate would correspond to higher over-polish sensitivity for dishing, which is undesirable.

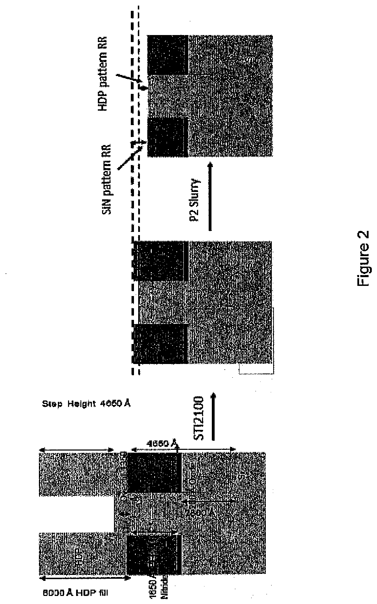

Figure 2 showed the wafer stack prior to polish, after the polish and describes how the pattern removal rates are calculated.

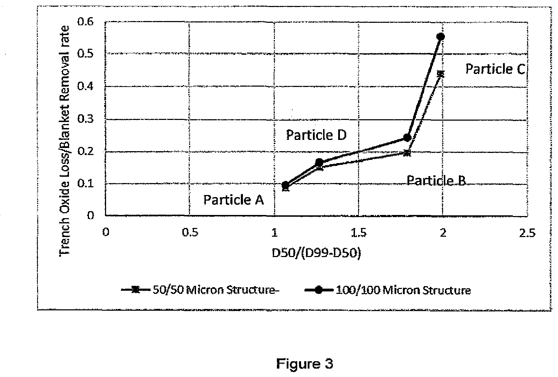

Figure 3 plotted the ratio of the trench oxide loss rate to blanket oxide removal rate as the function of D50/(D90-D50) for the CMP slurries with different particles.

It is evident that smaller particles (such as particle D with size distribution of D50/(D90-D50) =1.27) yields lower over-polish sensitivity. Moreover, as the particle size increases, the dishing for larger 100 micron features become even worse.

A wider particle distribution (such as particle A with D50/(D90-D50) =1.07) also showed significantly lower over-polish sensitivity compared to particle B of similar size. Dishing in CMP slurries made with particle A also seemed insensitive to line-width.

Trench loss for a wide 100 micron feature was comparable to 50 micron feature which is very desirable.

## Claims

1. A polishing method for chemical mechanical planarization (CMP) of a semiconductor substrate comprising at least one surface having at least one oxide layer, wherein the oxide layer includes TEOS and high density plasma (HDP) silicon dioxide, comprising the steps of:
a) contacting the at least one oxide layer with a polishing pad;
b) delivering a CMP polishing composition comprising;
(1) 0.01 wt.% to 20 wt.% of composite particles comprising core particles selected from the group consisting of silica, alumina, titania, zirconia, polymer particles, and combinations thereof; and nanoparticles selected from the group consisting of oxides of zirconium, titanium, iron, manganese, zinc, cerium, yttrium, calcium, magnesium, fluorine, lanthanum, and strontium, and combinations thereof; wherein the composite particles have a particle size distribution of D50/(D99-D50) ≤ 1.85; D99 is a particle size that 99 wt.% of the composite particles fall on and under, and D50 is a particle size that 50 wt.% of the composite particles fall on and under;
(2) water soluble solvent selected from the group consisting of water, a polar solvent and a mixture of water and polar solvent; wherein the polar solvent is selected from the group consisting of alcohol, ether, ketone, or other polar reagent;
(3) wherein the pH of the CMP composition is in the range of 2 to 12; and wherein the composition optionally further comprises one or more of (4) 0.0001 wt.% to 5 wt.% of a pH adjusting agent selected from the group consisting of sodium hydroxide, cesium hydroxide, potassium hydroxide, cesium hydroxide, ammonium hydroxide, quaternary organic ammonium hydroxide, and combinations thereof;
(5) 0.000001 wt.% to 5 wt.% of a chemical additive selected from the group consisting of a compound selected from the group consisting of organic carboxylic acids, amino acids, amide carboxylic acids, N-acylamino acids, and salts thereof; organic sulfonic acids and salts thereof; organic phosphonic acids and salts thereof; polymeric carboxylic acids and salts thereof; polymeric sulfonic acids and salts thereof; polymeric phosphonic acids and salts thereof; arylamines, amino alcohols, aliphatic amines, heterocyclic amines, hydroxamic acids, substituted phenols, sulfonamides, thiols, polyols having hydroxyl groups, and combinations thereof;
(6) 0.0001 wt.% to 10 wt.% of a surfactant selected from the group consisting of a). Non-ionic surface wetting agents; b). Anionic surface wetting agents; c). Cationic surface wetting agents; d). ampholytic surface wetting agents; and mixtures thereof;
(7) 0.01 wt.% to 3.0 wt.% of chelators;
(8) corrosion inhibitor;
(9) oxidizer; and
(10) biological growth inhibitor; and
c) polishing the at least one oxide layer with the CMP polishing composition, wherein the ratio of removal rate of TEOS to removal rate of HDP silicon dioxide film is < 1.

2. The method of Claim 1, wherein the composite particles comprise silica core particles and ceria nanoparticles such that the composite particles are ceria coated silica particles.

3. The method of Claim 1 or Claim 2, wherein the composite particles have D50 between 20 nm and 200 nm.

4. The method of any one of the preceding claims, wherein the composite particles have the particle size distribution of D50/(D99-D50) ≤ 1.50.

5. The method of Claim 4, wherein the composite particles have the particle size distribution of D50/(D99-D50) ≤ 1.30.

6. The method of any one of the preceding claims, wherein the CMP polishing composition comprises ceria coated silica particles and polyacrylate of molecular weight 16000-18000; and has a pH between 4 and 7.

## Patentansprüche

1. Polierverfahren für eine chemisch-mechanische Planarisierung (CMP) eines Halbleitersubstrats, das wenigstens eine Oberfläche umfasst, die wenigstens eine Oxidschicht aufweist, wobei die Oxidschicht ein TEOS und ein Hochdichtes-Plasma(HDP)-Siliciumdioxid beinhaltet, das die folgenden Schritte umfasst:
a) Inberührungbringen der wenigstens einen Oxidschicht mit einem Polierkissen;
b) Liefern einer CMP-Polierzusammensetzung, die Folgendes umfasst;
(1) 0,01 Gew.-% bis 20 Gew.-% Verbundpartikel, die Folgendes umfassen: Kernpartikel, die aus der Gruppe ausgewählt sind, die aus Siliciumdioxid, Aluminiumoxid, Titandioxid, Zirconiumdioxid, Polymerpartikeln und Kombinationen davon besteht; und Nanopartikel, die aus der Gruppe ausgewählt sind, die aus Oxiden von Zirconium, Titan, Eisen, Mangan, Zinc, Cerium, Yttrium, Calcium, Magnesium, Fluor, Lanthan und Strontium und Kombinationen davon besteht; wobei die Verbundpartikel eine Partikelgrößenverteilung von D50/(D99-D50) ≤ 1,85 aufweisen; wobei D99 eine Partikelgröße ist, auf oder unter die 99 Gew.-% der Verbundpartikel fallen, und D50 eine Partikelgröße ist, auf oder unter die 50 Gew.-% der Verbundpartikel fallen;
(2) wasserlösliches Lösungsmittel, das aus der Gruppe ausgewählt ist, die aus Wasser, einem polaren Lösungsmittel und einer Mischung aus Wasser und dem polaren Lösungsmittel besteht; wobei das polare Lösungsmittel aus der Gruppe ausgewählt ist, die aus Alkohol, Ether, Keton oder einem anderen polaren Reagens besteht;
(3) wobei der pH-Wert der CMP-Zusammensetzung in dem Bereich von 2 bis 12 liegt; und wobei die Zusammensetzung optional ferner eines oder mehrere von Folgenden umfasst:
(4) 0,0001 Gew.-% bis 5 Gew.-% eines pH-Werteinstellmittels, das aus der Gruppe ausgewählt ist, die aus Natriumhydroxid, Kaliumhydroxid, Cäsiumhydroxid, Kaliumhydroxid, Cäsiumhydroxid, Ammoniumhydroxid, quaternärem organischem Ammoniumhydroxid und Kombinationen davon besteht;
(5) 0,000001 Gew.-% bis 5 Gew.-% eines chemischen Zusatzstoffs, der aus der Gruppe ausgewählt ist, die aus einer Verbindung besteht, die aus der Gruppe ausgewählt ist, die aus Folgendem besteht: organischen Carbonsäuren, Aminosäuren, Amidcarbonsäuren, N-Acylaminosäuren und Salzen davon; organischen Sulfonsäuren und Salzen davon; organischen Phosphonsäuren und Salzen davon; polymeren Carbonsäuren und Salzen davon; polymeren Sulfonsäuren und Salzen davon; polymeren Phosphonsäuren und Salzen davon; Arylaminen, Aminoalkoholen, aliphatischen Aminen, heterocyclischen Aminen, Hydroxamsäuren, substituierten Phenolen, Sulfonamiden, Thiolen, Polyolen, die Hydroxylgruppen aufweisen, und Kombinationen davon;
(6) 0,0001 Gew.-% bis 10 Gew.-% eines Surfactants, das aus der Gruppe ausgewählt ist, die aus Folgendem besteht: a). nichtionischen Oberflächenbenetzungsmitteln; b). anionischen Oberflächenbenetzungsmitteln; c). kationischen Oberflächenbenetzungsmitteln; d). ampholytischen Oberflächenbenetzungsmitteln; und Mischungen davon;
(7) 0,01 Gew.-% bis 3,0 Gew.-% Chelatoren;
(8) einen Korrosionsinhibitor;
(9) ein Oxidationsmittel; und
(10) einen biologischen Wachstumsinhibitor; und
c) Polieren der wenigstens einen Oxidschicht mit der CMP-Polierzusammensetzung, wobei das Verhältnis einer Entfernungsrate von dem TEOS zu der Entfernungsrate des HDP-Siliciumdioxidfilms < 1 ist.

2. Verfahren nach Anspruch 1, wobei die Verbundpartikel Siliciumdioxidkernpartikel und Cerdioxidnanopartikel derart umfassen, dass die Verbundpartikel mit Cerdioxid beschichtete Siliciumdioxidpartikel sind.

3. Verfahren nach Anspruch 1 oder 2, wobei die Verbundpartikel einen D50 zwischen 20 nm und 200 nm aufweisen.

4. Verfahren nach einem der vorhergehenden Ansprüche, wobei die Verbundpartikel die Partikelgrößenverteilung von D50/(D99-D50) ≤ 1,50 aufweisen.

5. Verfahren nach Anspruch 4, wobei die Verbundpartikel die Partikelgrößenverteilung von D50/(D99-D50) ≤ 1,30 aufweisen.

6. Verfahren nach einem der vorhergehenden Ansprüche, wobei die CMP-Polierzusammensetzung mit Cerdioxid beschichtete Siliciumdioxidpartikel und Polyacrylat mit einer Molekularmasse von 16000-18000 umfasst; und einen pH-Wert zwischen 4 und 7 aufweist.

## Revendications

1. Procédé de polissage pour planarisation chimico-mécanique (CMP) d'un substrat semiconducteur comprenant au moins une surface ayant au moins une couche d'oxyde, dans lequel la couche d'oxyde comporte le TEOS et le dioxyde de silicium à plasma haute densité (HDP), comprenant les étapes suivantes :
a) la mise en contact de l'au moins une couche d'oxyde avec un tampon de polissage ;
b) la livraison d'une composition de polissage CMP comprenant ;
(1) 0,01 % en poids à 20 % en poids de particules composites comprenant des particules centrales choisies dans le groupe constitué de silice, d'alumine, de titane, de zircone, de particules polymères et de leurs combinaisons ; et des nanoparticules choisies dans le groupe constitué d'oxydes de zirconium, de titane, de fer, de manganèse, de zinc, de cérium, d'yttrium, de calcium, de magnésium, de fluor, de lanthane et de strontium, et leurs combinaisons ; dans lequel les particules composites ont une distribution granulométrique de D50/(D99-D50) ≤ 1,85 ; D99 est une taille de particule sur laquelle tombent 99 % en poids des particules composites et en dessous, et D50 est une taille de particule sur laquelle tombent 50 % en poids des particules composites et en dessous ;
(2) un solvant hydrosoluble choisi dans le groupe constitué d'eau, d'un solvant polaire et d'un mélange d'eau et de solvant polaire ; dans lequel le solvant polaire est choisi dans le groupe constitué d'alcool, d'éther, de cétone ou d'un autre réactif polaire ;
(3) dans lequel le pH de la composition CMP est dans la plage de 2 à 12 ; et dans lequel la composition comprend en outre éventuellement un ou plusieurs parmi
(4) 0,0001 % en poids à 5 % en poids d'un agent d'ajustement du pH choisi dans le groupe constitué par l'hydroxyde de sodium, l'hydroxyde de césium, l'hydroxyde de potassium, l'hydroxyde de césium, l'hydroxyde d'ammonium, l'hydroxyde d'ammonium organique quaternaire et leurs combinaisons ;
(5) 0,000001 % en poids à 5 % en poids d'un additif choisi parmi un groupe constitué par un composé choisi dans le groupe constitué par les acides organiques carboxyliques, les acides aminés, les acides amidocarboxyliques, les acides N-acylaminés et leurs sels ; les acides organiques sulfoniques et leurs sels ; les acides organiques phosphoniques et leurs sels ; les acides carboxyliques polymères et leurs sels ; les acides sulfoniques polymères et leurs sels ; les acides phosphoniques polymères et leurs sels ; les arylamines, les amino-alcools, les amines aliphatiques, les amines hétérocycliques, les acides hydroxamiques, les phénols substitués, les sulfonamides, les thiols, les polyols ayant des groupes hydroxyles, et leurs combinaisons ;
(6) 0,0001 % en poids à 10 % en poids d'un tensioactif choisi dans le groupe constitué de a). Agents mouillants de surface non ioniques ; b). Agents mouillants de surface anioniques ; c). Agents mouillants de surface cationiques ; d). Agents mouillants de surface ampholytique ; et leurs mélanges ;
(7) 0,01 % en poids à 3,0 % en poids de chélateurs ;
(8) un inhibiteur de corrosion ;
(9) un oxydant ; et
(10) un inhibiteur de croissance biologique ; et
c) le polissage d'au moins une couche d'oxyde avec la composition de polissage CMP, dans lequel le rapport du taux d'élimination de TEOS au taux d'élimination du film de dioxyde de silicium HDP est < 1.

2. Procédé selon la revendication 1, dans lequel les particules composites comprennent des particules centrales de silice et des nanoparticules de cérium de sorte que les particules composites sont des particules de silice revêtues de cérium.

3. Procédé selon la revendication 1 ou la revendication 2, dans lequel les particules composites ont un D50 compris entre 20 nm et 200 nm.

4. Procédé selon l'une quelconque des revendications précédentes, dans lequel les particules composites ont une distribution granulométrique de D50/(D99-D50) ≤ 1,50.

5. Procédé selon la revendication 4, dans lequel les particules composites ont une distribution granulométrique de D50/(D99-D50) ≤ 1,30.

6. Procédé selon l'une quelconque des revendications précédentes, dans lequel la composition de polissage CMP comprend des particules de silice revêtues de cérium et un polyacrylate de poids moléculaire compris entre 16 000 et 18 000 ; et a un pH compris entre 4 et 7.
